# EUROPEAN PATENT APPLICATION

(11) **EP 2 426 714 A1**
(43) Date of publication of application: **07.03.2012**
(21) Application number: 10769514.0
(22) Date of filing: 28.04.2010
(51) Int. Cl.: H01L 25/065, H01L 23/473, H01L 25/07, H01L 25/18, H05K 1/11, H05K 3/46

(54) **DEVICE MOUNTING STRUCTURE AND DEVICE MOUNTING METHOD**

(30) Priority: 28.04.2009 JP 2009109926
(71) Applicant: Fujikura, Ltd., Tokyo 135-8512 (JP)
(72) Inventor: YAMAMOTO, Satoshi, Chiba 285-8550 (JP); HASHIMOTO, Hirokazu, Chiba 285-8550 (JP)
(74) Representative: Cabinet Plasseraud
(86) International application number: PCT/JP2010/003044
(87) International publication number: WO 2010/125814

(57) **Abstract**

A device mounting structure including: a interposer substrate that includes a substrate and a plurality of through-hole interconnection that are formed within a plurality of through holes that penetrate the substrate from a first principal surface that is one principal surface of the substrate to a second principal surface that is the other principal surface; a first device that includes a plurality of electrodes, with the electrodes arranged so as to face the first principal surface; and a second device that includes a plurality of electrodes whose arrangement is different from the arrangement of the electrodes of the first device, with the electrodes arranged so as to face the second principal surface, wherein each through-hole interconnection includes a first conductive portion that is provided at a position on the first principal surface corresponding to the electrode of the first device, and a second conductive portion that is provided at a position on the second principal surface corresponding to the electrode of the second device, each electrode of the first device is electrically connected with the first conductive portion, and each electrode of the second device is electrically connected with the second conductive portion.

## Description

### TECHNICAL FIELD

The present invention relates to a device mounting structure for mounting a device on both surfaces of an interposer substrate that has through-hole interconnections that penetrate the substrate, and to a device mounting method.
Priority is claimed on Japanese Patent Application No. 2009-109926, filed April 28, 2009, the content of which is incorporated herein by reference.

### BACKGROUND ART

Conventionally, methods of providing through-hole interconnections that penetrate a substrate have been widely used as a method of electrically connecting devices that are mounted on both surface of a substrate.

As an example of a substrate that has through-hole interconnections, Patent Document 1 discloses a substrate that is provided with through-hole interconnections formed by filling an electrically conductive substance in a micro hole having a portion that extends in a different direction from the thickness direction of the substrate.

### [Prior Art Documents]

### [Patent Document]

[Patent Document 1] Japanese Unexamined Patent Application, First Publication No. 2006-303360

### DISCLOSURE OF INVENTION

### PROBLEMS TO BE SOLVED BY THE INVENTION

In the case where the types of devices to be mounted on both surfaces of the substrate are mutually different, the arrangement of the electrodes (I/O connects) necessary for each device differs. For that reason, surface wiring is needed in order to resolve this difference. Also, in order to avoid short circuiting of wiring or interference of electrical signals that flow through the wiring, it is necessary to provide a predetermined interval (space) between the wiring. However, in the case of providing surface wiring as described above on the principal surfaces of the substrate, the surface area that the surface wiring occupies on the principal surfaces increases, and as a result the device arrangement on the substrate may be severely restricted. Also, a longer wiring length may cause, for example, signal delays and a deterioration in the high-frequency characteristics.

Moreover, in the case of there being numerous electrodes on the surface of each device facing the substrate, the aforementioned surface wiring is not sufficient. In this case, it is necessary to employ a multi-layer wiring structure including multiple wiring layers that are connected by inter-layer vias. For that reason, problems arise such as an increase in the wiring length due to the multi-layer wiring, and an accompanying deterioration of the high-frequency characteristics, and the substrate manufacturing process also becomes cumbersome.

The present invention was achieved in view of the above circumstances, and has an object of providing a device mounting structure and a device mounting method that, with respect to devices in which electrodes are arranged at a high density and with differing layouts, can freely connect the electrodes of the devices mounted on both surfaces of an interposer substrate, without employing a multi-layer wiring structure.

### MEANS FOR SOLVING THE PROBLEMS

In order to solve the aforementioned issue, the present invention employs the following. In particular, the device mounting structure according to a first aspect of the present invention includes: an interposer substrate that includes a substrate and a plurality of through-hole interconnections that are formed within a plurality of through holes that penetrate the substrate from a first principal surface that is one principal surface of the substrate to a second principal surface that is the other principal surface; a first device that includes a plurality of electrodes, with the electrodes arranged so as to face the first principal surface; and a second device that includes a plurality of electrodes whose arrangement is different from the arrangement of the electrodes of the first device, with the electrodes arranged so as to face the second principal surface, wherein each through-hole interconnections includes a first conductive portion that is provided at a position on the first principal surface corresponding to the electrode of the first device, and a second conductive portion that is provided at a position on the second principal surface corresponding to the electrode of the second device, each electrode of the first device is electrically connected with the first conductive portion, and each electrode of the second device is electrically connected with the second conductive portion.
It is preferable that each through wire have substantially a linear shape that connects the first conductive portion and the second conductive portion.
It is preferable that a fluidic channel be provided within the substrate.

Moreover, a device mounting method according to a second aspect of the present invention includes: a step of preparing a first device that includes a plurality of electrodes, and a second device that includes a plurality of electrodes whose arrangement differs with the arrangement of the electrodes of the first device; a through hole formation step of forming a plurality of through holes that penetrate a substrate from a first principal surface that is one principal surface of the substrate to a second principal surface that is the other principal surface of the substrate so as to open at positions of the first principal surface corresponding to the electrodes of the first device, and at positions of the second principal surface corresponding to the electrodes of the second device; a through-hole interconnection formation step, by filling each of the through holes with a conductor or forming a film of the conductor in each of the through holes, forming through-hole interconnections that include a first conductive portion exposed at the first principal surface side and a second conductive portion exposed at the second principal surface side; and a mounting step of arranging the first device so as to face the first principal surface of the substrate and connecting each electrode of the first device to the corresponding first conductive portion, and arranging the second device so as to face the second principal surface of the substrate and connecting each electrode of the second device to the corresponding second conductive portion.
It is preferable that a fluidic channel be formed within the substrate in the through-hole interconnections formation step.
It is preferable that the through hole formation step include a step of modifying the regions where the through holes are to be formed and the regions where the fluidic channels are to be formed in the substrate, and a step of removing the modified regions by etching.

### EFFECTS OF THE INVENTION

According to the present invention, since it is possible to electrically connect electrodes of devices that have been mounted on both sides of an interposer substrate without surface wires, it is possible to freely connect even small devices whose electrodes are arranged with a high density.

### BRIEF DESCRIPTION OF THE DRAWINGS

FIG 1A is a plan view that shows the device mounting structure according to an embodiment of the present invention.
FIG 1B is a cross-sectional view along line A-A in FIG 1A.
FIG 2A is a plan view of the interposer substrate that is used in the device mounting structure shown in FIG 1A and FIG 1B.
FIG 2B is a cross-sectional view along line B-B in FIG 2A.
FIG 3 is a perspective view of the interposer substrate that is shown in FIG 2A and FIG 2B.
FIG 4A is a plan view that shows the device mounting structure according to a first modified example of the embodiment.
FIG 4B is a cross-sectional view along line C-C of FIG 4A.
FIG 5A is a plan view that shows the device mounting structure according to a second modified example of the embodiment.
FIG 5B is a cross-sectional view along line D-D of FIG 5A.
FIG 6A is a plan view that shows the device mounting structure according to a third modified example of the embodiment.
FIG 6B is a cross-sectional view along line E-E of FIG 6A.
FIG 7 is a partial plan view that schematically shows the connection relation of the electrodes in the portion of the lower-left quarter of the device mounting structure shown in FIG 6A and FIG 6B.
FIG 8 is a cross-sectional view that shows an example in which bumps are provided on the device mounting structure according to the present invention.
FIG 9 is a cross-sectional view that shows an example in which a molded resin layer is provided on the device mounting structure according to the present invention.
FIG 10 is a cross-sectional view that shows an example in which a protective member having a cavity is provided on the device mounting structure according to the present invention.
FIG 11A is a plan view that shows a first example of an interposer substrate that has fluidic channels.
FIG 11B is a cross-sectional view along line I-I of FIG 11A.
FIG 11C is a cross-sectional view along line J-J of FIG 11A.
FIG 12A is a plan view that shows a second example of an interposer substrate that has a fluidic channel.
FIG 12B is a cross-sectional view along line K-K of FIG 12A.
FIG 12C is a cross-sectional view along line L-L of FIG 12A.
FIG 13A is a plan view that shows a third example of an interposer substrate that has a fluidic channel.
FIG 13B is a cross-sectional view along line M-M of FIG 13A.
FIG 13C is a cross-sectional view along line N-N of FIG 13A.
FIG 14A is a cross-sectional view that shows the first stage of the manufacturing method of the interposer substrate that has fluidic channels.
FIG 14B is a cross-sectional view that shows the stage following FIG 14A.
FIG 14C is a cross-sectional view that shows the stage following FIG 14B.
FIG 14D is a cross-sectional view that shows the stage following FIG 14C.
FIG 14E is a cross-sectional view that shows the stage following FIG 14D.

### EMBODIMENTS FOR CARRYING OUT THE INVENTION

Hereinbelow, the preferred embodiments of the present invention shall be described with reference to the drawings.

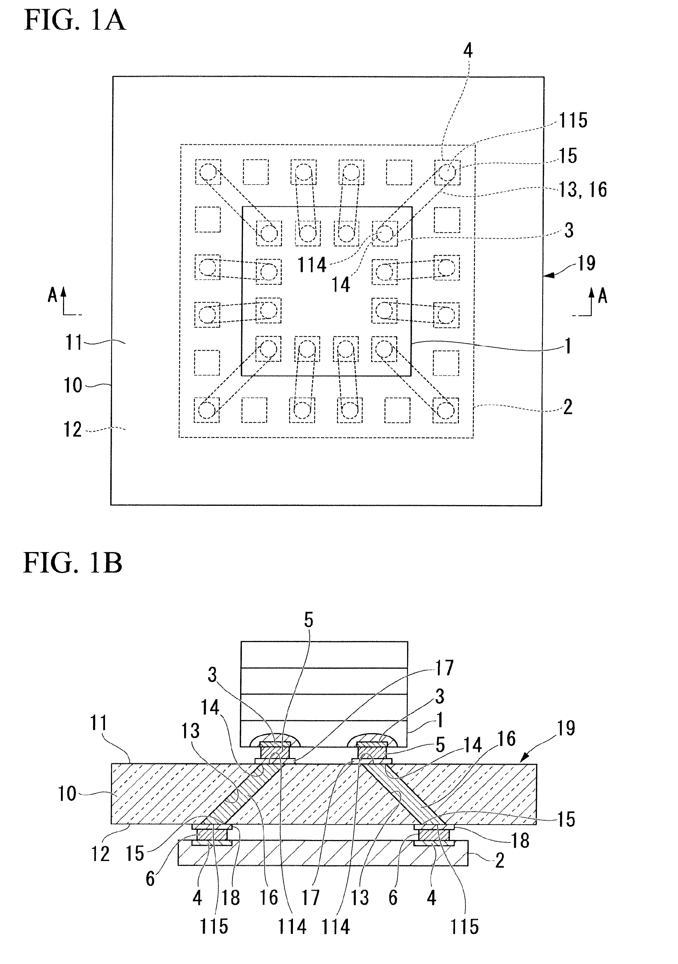

FIGS. 1A to FIG 3 show the device mounting structure according to an embodiment of the present invention. This device mounting structure includes: an interposer substrate 19 that has a substrate 10, and a plurality of through-hole interconnections 16 that are formed in a plurality of through holes 13 that penetrate the substrate 10 from one principal surface (hereinbelow the first principal surface) 11 of the substrate 10 to the other principal surface (hereinbelow the second principal surface) 12; a first device 1 that has a plurality of electrodes 3, with these electrodes 3 being arranged so as to face the first principal surface 11; and a second device 2 that has a plurality of electrodes 4 whose arrangement is different from the arrangement of the electrodes 3 of the first device 1, with these electrodes 4 being arranged so as to face the second principal surface, in which each through hole 13 has a first conductive portion 114 that is provided at a position on the first principal surface 11 corresponding to the electrode 3 of the first device 1, and a second conductive portion 115 provided at a position on the second principal surface 12 corresponding to the electrode 4 of the second device 2, and each electrode 3 of the first device 1 is electrically connected to the first conductive portion 114, and each electrode 4 of the second device 2 is electrically connected to the second conductive portion 115.
Thereby, since the plurality of electrodes 3 of the first device 1 and the plurality of electrodes 4 of the second device 2 are electrically connected via the plurality of through wires 16, it is possible to achieve nearly the shortest connection between the electrodes 3 and 4. Each through-hole interconnection 16 preferably has substantially a linear shape that connects the first conductive portion 114 and the second conductive portion 115.

In the present invention, an electrode arrangement (layout) of a device means the two-dimensional arrangement of electrodes of the device to be connected with through-hole interconnections, within a plane that faces the principal surface of the interposer substrate. That is, simply by subjecting the entire device to parallel displacement, the positions of all the electrodes are shifted by the same distance in the same direction, so that the electrode arrangement of the device does not change. In the case of the distance between two corresponding electrodes, or the angle between three corresponding electrodes differing at at least one location between two devices, the electrode arrangement of these two devices will mutually differ. For example, in the case of the electrode arrangement of two devices being in a similar relation in which only the electrode pitch differs, the electrode arrangement of these two devices will mutually differ. Also, even in the case of the electrodes of the two devices consisting of a plurality of blocks having the exact same layout, in the case of these block positions differing between the two devices, the electrode arrangement of these two devices will mutually differ. Moreover, in an electrode layout, electrodes that are not connected with through-hole interconnections are excluded even if they exist, and only electrodes that are connected with through-hole interconnections are considered.

Provided that the electrode arrangements of the devices to be mounted on both surfaces are the same, if all of the through-hole interconnections are formed perpendicularly to the principal surface of the substrate or all the through-hole interconnections are obliquely formed in the same direction (parallel), it is possible to connect the electrodes of both devices in a one-to-one corresponding relationship via these through-hole interconnections. However, in the present invention, the electrode arrangements of both devices mutually differ. For this reason, in the case of all of the through-hole interconnections being formed perpendicularly with respect to the principal surface of the substrate or obliquely formed so as to be mutually parallel, the positions of the electrodes of at least one of the devices and the conductive portions will not meet, and thus surface wiring will be required. In the present invention, in order to omit surface wiring for connecting between the devices, the arrangement of first conductive portions 114 (first opening portions 14) on the first principal surface 11 and the electrode arrangement of the first device 1 are made corresponding to each other, and the arrangement of second conductive portions 115 (second opening portions 15) on the second principal surface 12 and the electrode arrangement of the second device 2 are made corresponding to each other. Thereby, it is possible to connect the device 1 and device 2 without providing surface wiring on the interposer substrate 19.

In the example that is shown in FIGS. 1A to 3, the electrode arrangements of both devices 1 and 2 are peripheral arrangements in which the electrodes 3 and 4 are lined up at the edge portions of the devices 1 and 2, respectively. Moreover, the dimensions of both devices 1 and 2 (that is, the lengths in directions along the principal surfaces 11 and 12 of the substrate 10 and surface areas) mutually differ. The through-hole interconnections 16 of the interposer substrate 19 are formed to extend from the electrodes 3 of the device 1 having small dimensions toward the electrodes 4 of the device 2 having large dimensions. That is, the first conductive portions 114 are in the center of the first principal surface 11 of the substrate 10, the second conductive portions 115 are close to the outer periphery of the second principal surface 12 of the substrate 10, and thus the through-hole interconnections 16 extend in substantially a radial shape.

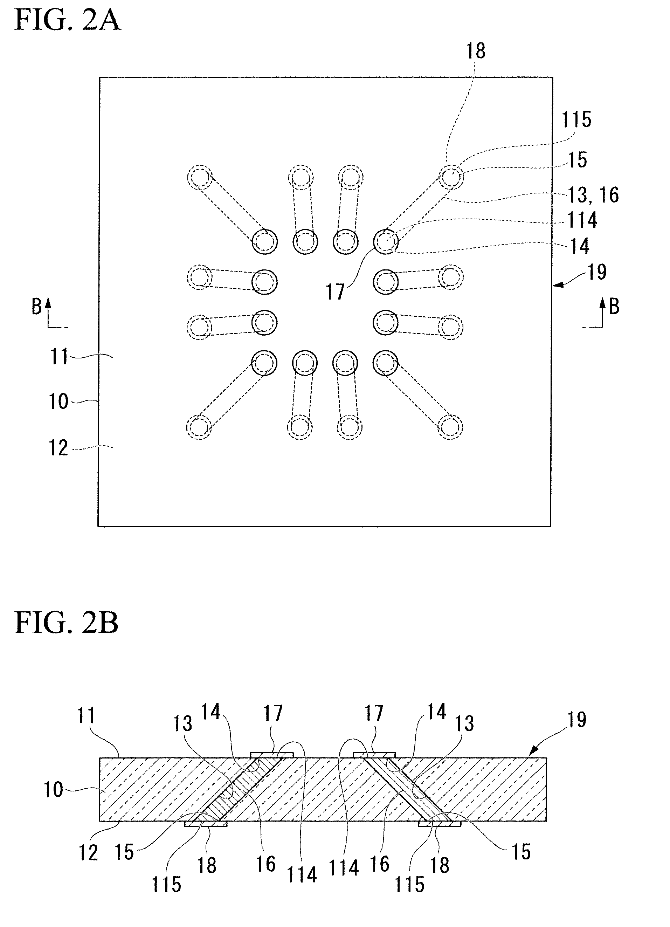

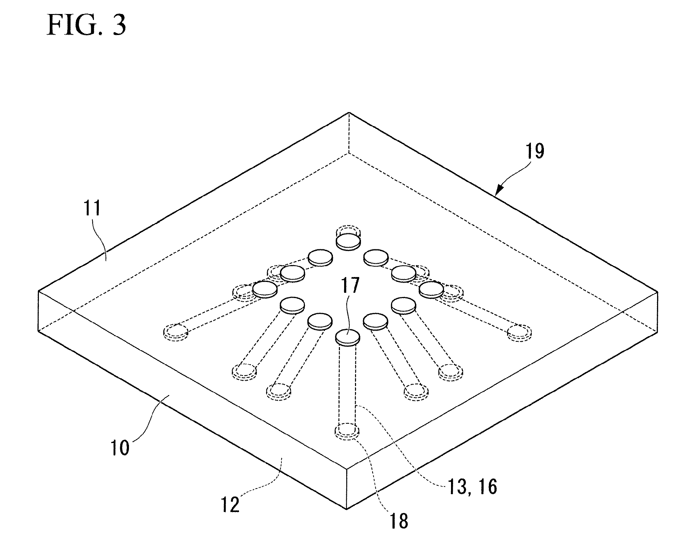

In this way, in the interposer substrate 19 of the present embodiment, all the through holes 13 in which the through-hole interconnections 16 are provided are not parallel to one another. For this reason, as the through hole 13 formation method, a method may be employed that is capable of forming the through holes 13 in a discretionary orientation, as described below.
Note that the orientation of the through holes 13 is not perceived in terms of a plan view seen from a direction perpendicular to the principal surfaces 11 and 12 of the substrate 10, but rather in a three-dimensional sense including the thickness direction of the substrate 10. For example, the through holes 13 that face the center of the substrate 10 in FIG 2A have the same orientation in plan view, but as shown in FIG 3, when viewed three-dimensionally the orientations differ from the first principal surface 11 side to the second principal surface 12 side, and thus are mutually not parallel.

The material of the substrate 10 may be an insulator such as glass, plastic, and ceramics, or a semiconductor such as silicon (Si). In the case of a semiconductor substrate, it is preferable to form an insulating layer on the inner wall of the through holes 13 and the principal surfaces 11 and 12. In the case of an electrically insulative substrate, there is no need to additionally form an insulating layer on the inner walls of the through holes 13.
Note that in the case where there is a large difference in linear expansion coefficient between the substrate of an electronic device and the substrate on which the electronic device is to be mounted on, since the amount of elongation of them, due to temperature when mounted, are greatly different from each other, positional displacement easily occurs between the electrodes of the electronic device and the conductive portions on the substrate that these electrodes are connected to. As a result, highly accurate connections between them may become difficult, and the connections themselves may become difficult.
In contrast, according to the present invention it is possible to use silicon or glass as the material of the substrate 10. Accordingly, for example, in the case of mounting the electronic devices 1 and 2 using a silicon substrate on both principal surfaces of the substrate 10, it is possible to reduce the aforementioned difference in linear expansion coefficient. As a result, the positional shifting between the electrodes of the electronic devices 1 and 2 and the conductive portions on the substrate 10 is inhibited, and it is possible to connect them with superior positional accuracy.

As described above, the through-hole interconnections 16 are provided by filling the through holes 13 with a conductor or forming a film of a conductor in the through holes 13, each of the through holes 13 including a first opening 14 that opens at a position on the first principal surface 11 of the substrate 10 facing the electrode 3 of the first device 1, and a second opening 15 that opens at a position on the second principal surface 12 of the substrate 10 facing the electrode 4 of the second device 2.
To form the through holes (micro holes) 13, a mechanical method such as a method that combines modification of silica glass using a femtosecond laser and wet etching as disclosed in Patent Document 1, or a mechanical method such as NC drilling may be employed. When performing material modification using a femtosecond laser, since the structure of the portion that is irradiated by the laser changes, and the resistance to an etchant decreases compared to the portions that has not been irradiated with the laser, it is possible to easily form the hole. The diameter of the micro hole 13 may substantially be constant between the openings 14 and 15, or may change in a tapered manner or stepwise manner. The inner diameter of the first opening 14 and the inner diameter of the second opening 15 may be different. In addition, in the vicinity of the openings 14 and 15, the hole diameter may have a structure that continuously or step-by-step expands from the interior of the substrate 10 to the principal surfaces 11 and 12.
The conductor that is used for the through-hole interconnection 16 includes metals such as copper (Cu) and tungsten (W), alloys such as Au-Sn, and nonmetallic conductors such as polysilicon. As the manufacturing method, it is possible to suitably employ a plating method, a sputtering method, a molten metal filling method, chemical vapor deposition, and a supercritical fluid deposition method and the like.

Note that it is preferable for the through-hole interconnection 16 to be formed by completely filling the interior of the micro hole 13 with a conductor. In the device mounting structure of the present invention, the electrodes 3 and the electrodes 4 of the devices are arranged so as to face the openings 14 and the openings 15 of the through-hole interconnection 16, respectively. For that reason, when the through-hole interconnection 16 has a solid construction in which the interior of the micro hole 13 is completely filled with the conductor, the stability of the connection increases both mechanically and electrically compared to the case of a hollow structure in which a conductive layer is formed only on the inner wall of the micro hole 13, and so is preferred.
As the method of completely filling the micro hole with the conductor as described above, it is possible to use any one of the methods among the plating method, sputtering method, molten metal filling method, chemical vapor deposition, and supercritical fluid deposition method. Also, these methods may be suitably combined. In particular, in the case of the hole length being long and the shape being complicated, a conductive thin film may be formed with a method that can form a film to the depth of the hole such as CVD and a supercritical fluid deposition method. With the conductive thin film serving as a seed layer or adhesive layer, it is possible to continuously perform completely filling the micro hole with a conductor in an efficient way by the plating method or molten metal filling method.

The devices 1 and 2 include integrated circuits such as memory (memory elements) and logic (logic elements), MEMS devices such as sensors, and optical devices such as light emitting elements and photo detectors. As far as the electrode arrangements of the devices 1 and 2 are different from each other, it does not matter whether their functions differ or their functions are the same. In particular, by integrating different types of devices with a high density, it is possible to realize a three-dimensional system in package (SiP).
In the case of the present embodiment, as shown in FIG 1B, a plurality of devices 1 are laminated on the substrate 10 on the first principal surface side 11. According to the present embodiment, further high density is possible.

The manufacture of the interposer substrate 19 includes forming the through holes 13 that each have the openings 14 and 15 corresponding to the electrode arrangements of the devices 1 and 2, respectively, (through hole formation step), forming the through-hole interconnection 16 that each have the first conductive portion 114 exposed at the first principal surface 11 side and the second conductive portion 115 exposed at the second principal surface 12 side by filling these through holes 13 with a conductor or forming a film of a conductor in these through holes 13 (through-hole interconnection formation step), and moreover mounting both devices 1 and 2 on both surfaces of the interposer substrate 19 by arranging the first device 1 so as to face the first principal surface 11 of the substrate 10 and connecting the electrodes 3 thereof to the corresponding first conductive portions 114, and arranging the second device 2 so as to face the second principal surface 12 of the substrate 10 and connecting the electrodes 4 thereof to the corresponding second conductive portions 115 (mounting step). Thereby, the plurality of electrodes 3 of the first device 1 and the plurality of electrodes 4 of the second device 2 are electrically connected via the plurality of through-hole interconnection 16.

In the case of the present embodiment, the electrodes 3 and 4 of each device 1 and 2 and the through-hole interconnection 16 are connected by land portions 17 and 18 that are provided at the opening portions 14 and 15 of the through holes 13, and joint materials 5 and 6 that are an electrically conductive material (such as solder or an electrically conductive bump) that are provided on these land portions 17 and 18. In the present invention, the land portions 17 and 18 and the joint materials 5 and 6 may be omitted. For example, the electrodes 3 and 4 and the through-hole interconnection 16 may be directly connected by solder.

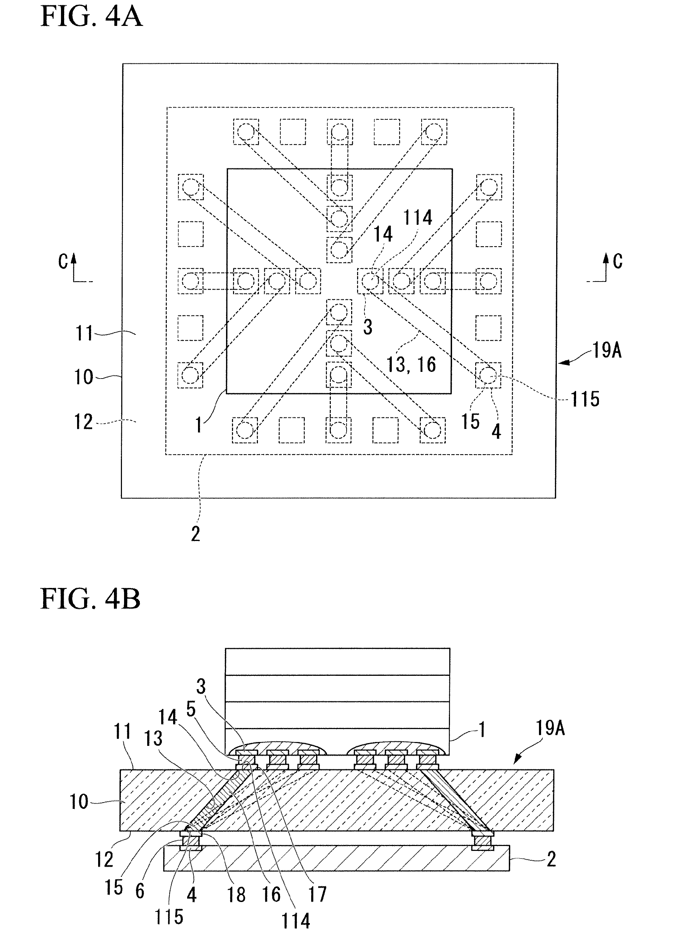

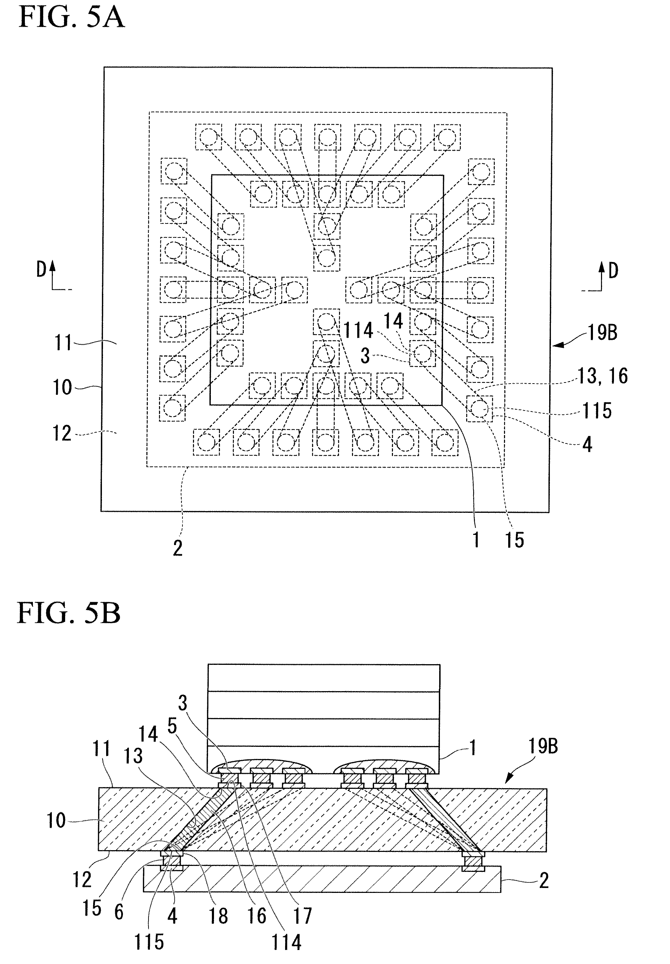

In the device mounting structure that is shown in FIGS. 1A to 3, the electrode arrangement of the devices 1 and 2 is a peripheral arrangement in which the electrodes 3 and 4 are lined up along the edge portion of the devices 1 and 2.
In the device mounting structure according to the first modified example of the present embodiment shown in FIG 4A and FIG 4B, the electrode arrangement of the first device 1 is an arrangement in which the electrodes 3 form a cross shape, and the electrode arrangement of the second device 2 is a peripheral arrangement in which the electrodes 4 are lined up at the edge portion of the device 2.
In the device mounting structure according to the second modified example of the present embodiment shown in FIG 5A and FIG 5B, the electrode arrangement of the first device 1 is a lattice arrangement in which the electrodes 3 are lined up at the edge portion and in a cross shape, and the electrode arrangement of the second device 2 is a peripheral arrangement in which the electrodes 4 are lined up at the edge portion of the device 2.

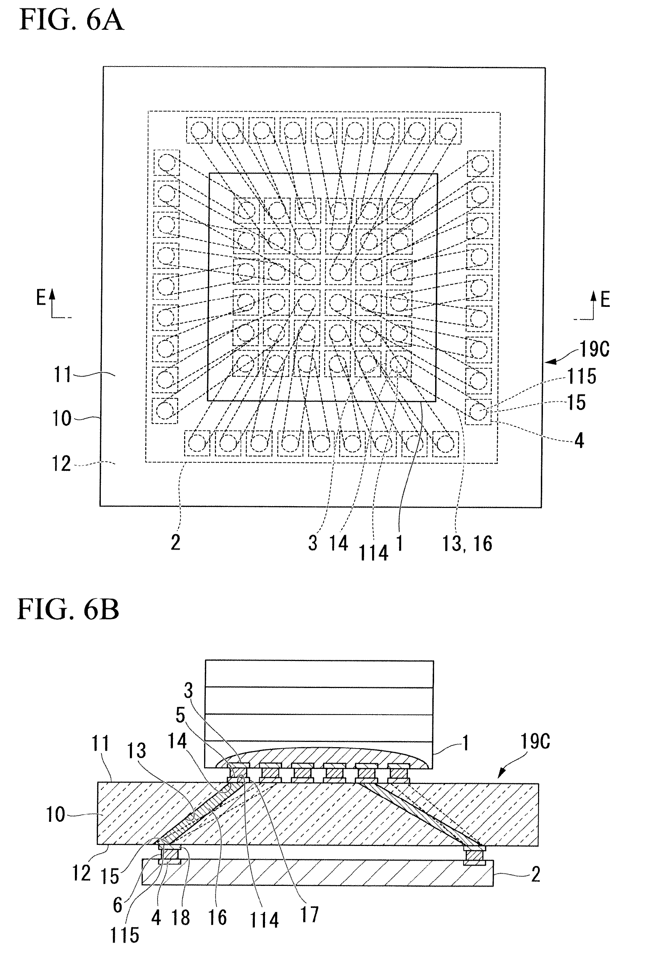

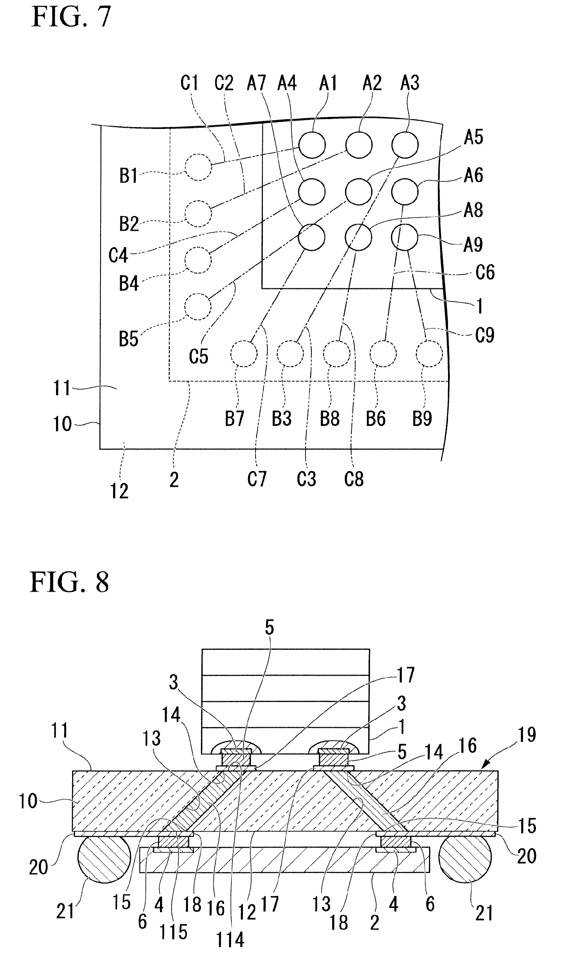

In the device mounting structure according to the third modified example of the present embodiment shown in FIGS. 6A and 6B, the electrode arrangement of the first device 1 is an area array arrangement in which the electrodes 3 are arranged horizontally and vertically, and the electrode arrangement of the second device 2 is a peripheral arrangement in which the electrodes 4 are lined up at the edge portion of the device 2. Note that FIG 7 schematically shows the connection relation of the electrodes at the portion in the lower-left quarter of the device mounting structure shown in FIGS. 6A and 6B.
Here, the reference numerals A1 to A9 denote the land portions 17 on the first principal surface 11 that are to be connected to the electrodes 3 of the first device 1. In addition, the reference numerals B1 to B9 denote the land portions 18 on the second principal surface 12 that are to be connected to the electrodes 4 of the second device 2. Moreover, the reference numerals C1 to C9 denote the through-hole interconnection 16 that respectively connect A1 to A9 and B1 to B9.
It should be noted that the present invention is not limited to the aforementioned example, and other electrode arrangements may be combined.

In the example shown in FIGS. 1A to 7, the dimensions in plan view of the second device 2 are greater than those of the first device 1 for convenience of explanation. In addition, the electrodes 4 of the second device 2 are peripherally arranged. However, in the present invention, the electrodes 4 of the second device 2 as in the above example may be arranged at positions that overlap with the first device 1 in plan view with respect to the substrate 10. In addition, the dimensions in plan view of the first device 1 may be the same as those of the second device 2.
In this manner, regardless of the respective electrode arrangements (layouts), on the devices 1 and 2, of the electrodes 3 and 4 of both devices 1 and 2, since it is possible to connect between the electrodes 3 and 4 in nearly the shortest distance, it contributes to a further increase in speed of the devices. Moreover, since it is possible to change the pitch between the wiring in the interposer substrates 19, 19A, 19B, 19C without adopting a multi-layer structure as in a build-up substrate, it is possible to efficiently connect between the electrodes 3 and 4 of both devices 1 and 2.

In the device mounting structure of the present invention, it is possible to provide bumps 21 made of solder or the like as shown in FIG 8. In the example shown in FIG 8, the interposer substrate 19 has connection terminals 21 such as solder bumps on the second principal surface 12 side of the substrate 10. It is possible to electrically connect the devices 1 and 2 and an outer substrate such as a printed circuit board (not illustrated) via the through-hole interconnection 16 and a circuit 20. The device 1 is layered on the first principal surface 11 side.

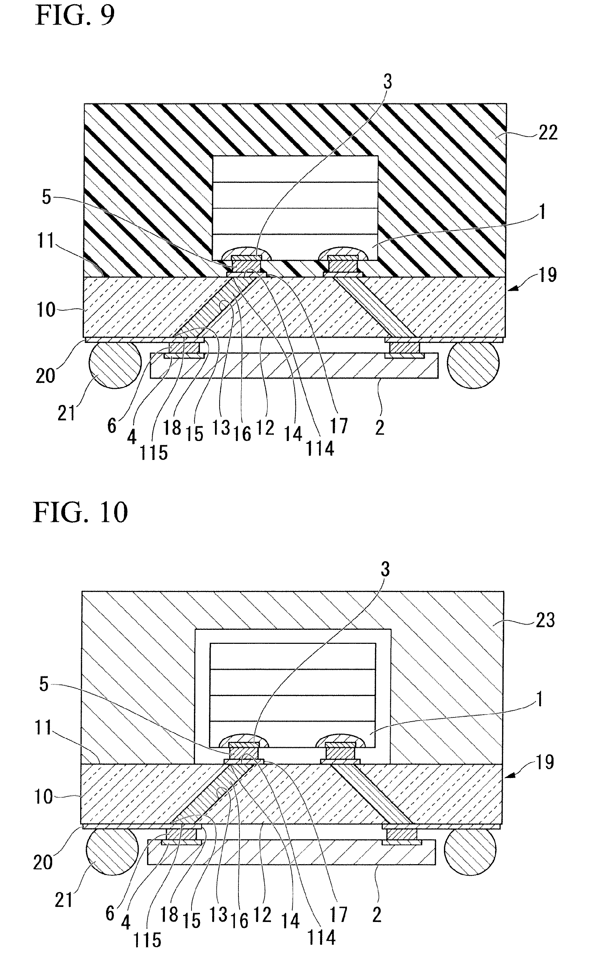

In the device mounting structure of the present invention, it is possible to cover the device 1 with a molded resin layer 22 as shown in FIG 9, and possible to cover the device 1 with a protective member 23 having a cavity as shown in FIG 10. Thereby, it is possible to protect the device 1.

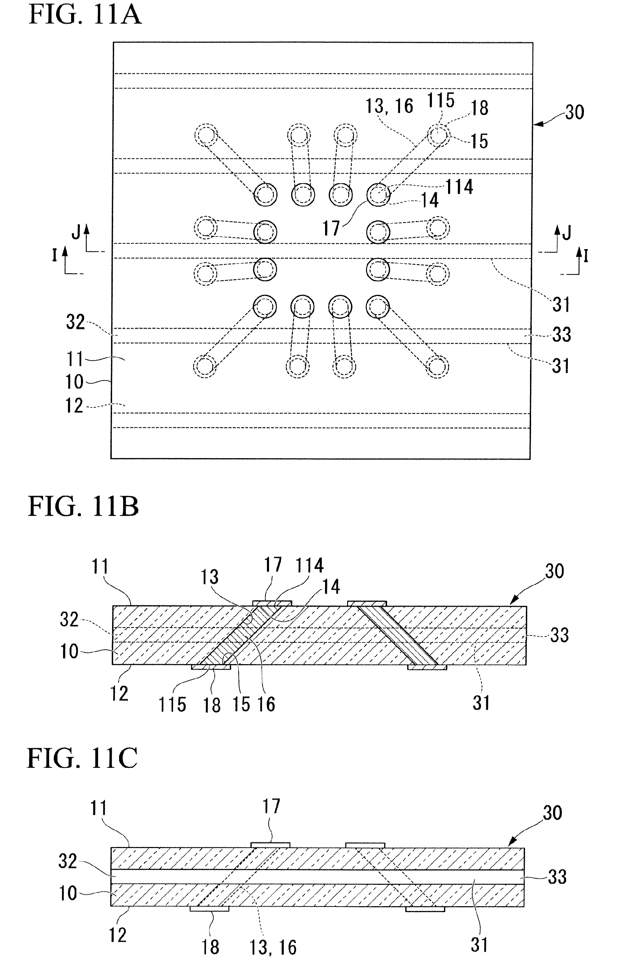

In addition, in the device mounting structure of the present invention, it is possible to provide a fluidic channel 31 within the substrate 10 as shown in FIGS. 11A to 13C. The fluidic channel 31 is used as a passage that circulates a cooling fluid such as water. In addition, the fluidic channel 31 can also be used as a passage for circulating biological fluids such as DNA (nucleic acid), protein material, and lipid.
In the case of using the fluidic channel 31 for circulating a cooling fluid, the first device and the second device are mounted on the first principal surface 11 side and the second principal surface 12 side, respectively, of the interposer substrates 30, 30A, 30B having a fluidic channel shown in FIGS. 11A to 13C, whereby it is possible to cool the interposer substrates 30, 30A, 30B having the fluidic channels. Thereby, even in the case of the electrodes of the first device and/or the second device being arranged at a high density, it is possible to effectively lower the temperature rise of the interposer substrates 30, 30A, 30B having fluidic channels. Hereinbelow, the case of using the fluidic channel 31 for flowing a cooling fluid shall be described.

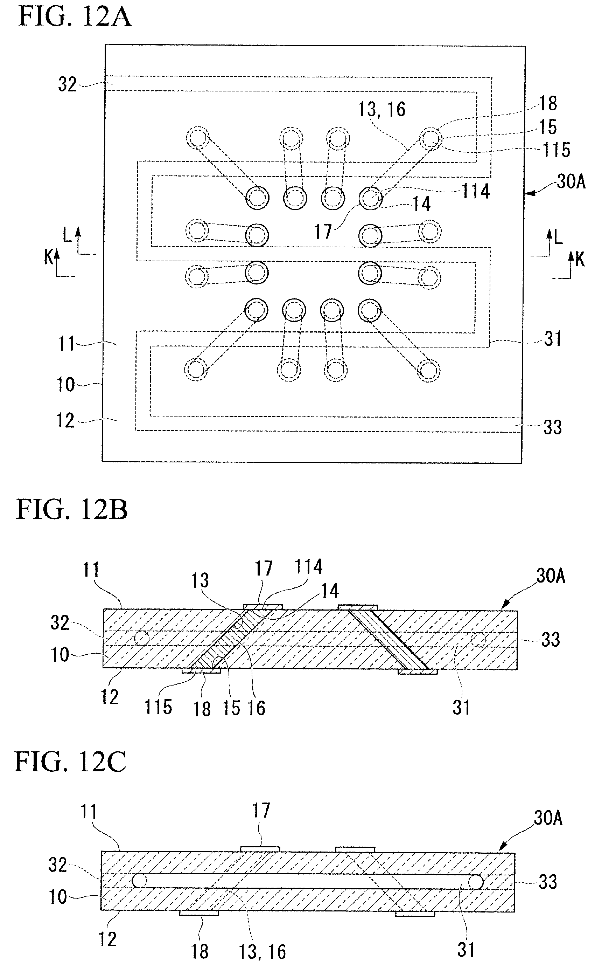

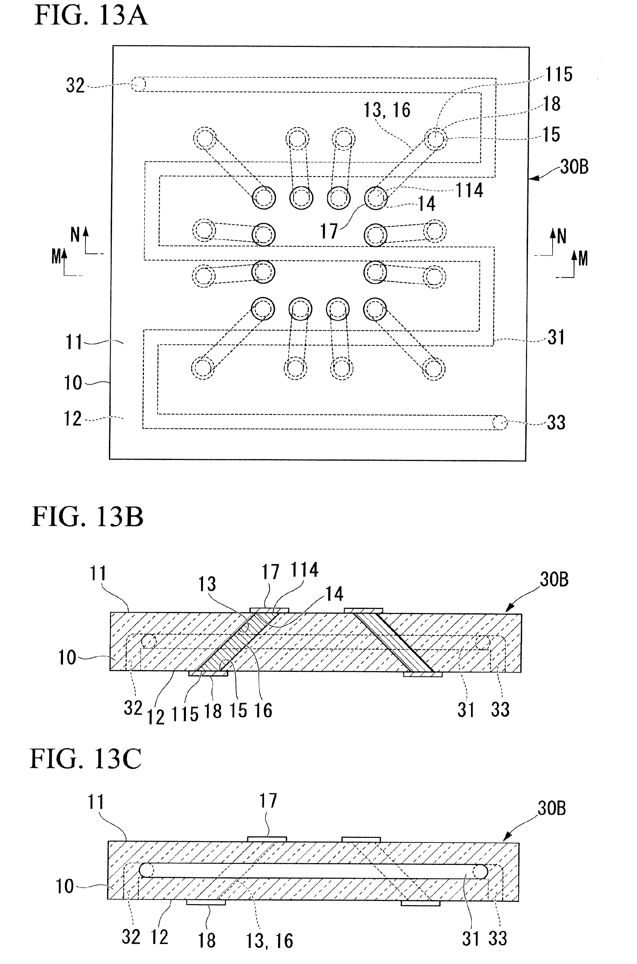

The fluidic channel 31 has an entry/exit 32, 33 at both ends thereof that admits and releases the cooling fluid.
As shown in FIGS. 11A to 11C, a plurality of the fluidic channels 31 may be provided.
In addition, as shown in FIG 12A, one fluidic channel 31 may have a meander shape so as to cool the entire substrate 10.
Also, as shown in FIGS. 13A to 13C, the entry/exit 32 and 33 of the fluidic channel 31 may open at the principal surface 12 of the substrate 10.
Note that the pattern (route) and cross-sectional shape of the fluidic channel 31 are not limited to the above examples, and can be suitably designed.

The fluidic channel 31 preferably has a predetermined clearance with the through hole 13 three-dimensionally in the surface direction or thickness direction so as to not communicate with the through hole 13, which has the through-hole interconnection 16.
In the present embodiment, since the through hole 13 is obliquely formed with respect to the principal surfaces 11 and 12 of the substrate 10, even when the fluidic channel 31 that is parallel to the principal surfaces 11 and 12 of the substrate 10 as shown in FIG 12A is viewed so as to overlap with the through hole 13 in plan view, the through hole 13 and the fluidic channel 31 are not communicated. That is, if the positions in the thickness direction of the substrate 10 are mutually displaced, the through hole 13 and the fluidic channel 31 are not communicated with each other.

It is preferable to form the fluidic channel 31 in the substrate 10 at the same time when forming the through hole 13 in which the through wire 16 is to be formed.

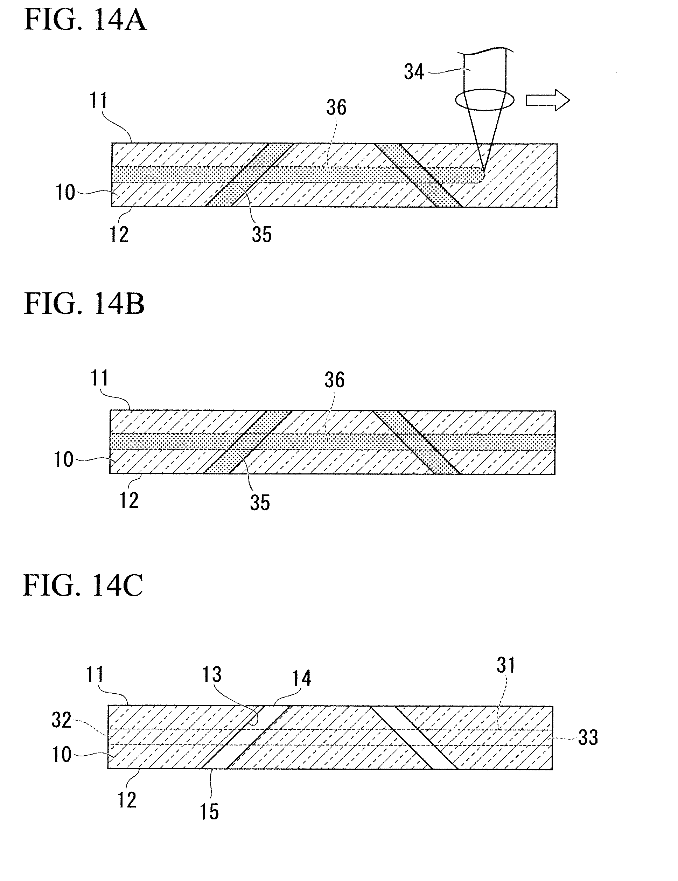

FIGS. 14A to 14E show examples of methods of manufacturing the aforementioned interposer substrate 30 having a fluidic channel.
First, as shown in FIGS. 14A and 14B, a laser light 34 is irradiated on the substrate 10, whereby the material of the substrate 10 is modified within the substrate 10 to form the modified portions 35 and 36. The modified portion 35 is provided in a region where the through hole 13 is to be formed, and the modified portion 36 is provided in a region where the fluidic channel 31 is to be formed.

In the present embodiment, a femtosecond laser is used as the light source of the laser light 34, and by irradiating the laser beam so as to be focused within the substrate 10, the modified portions 35 and 36 having a diameter of several µm to several tens of µm are obtained. By controlling the focus position of the laser light 34 within the substrate 10, it is possible to form the modified portions 35 and 36 in a desired shape. Note that generally the refractive index is changed in the modified portions 35 and 36 compared to the material of the substrate 10.

The modified portion 36 that becomes the fluidic channel 31 may be formed parallel with respect to the principal surfaces 11 and 12 of the substrate 10, as shown in FIGS. 14A to 14E. At this time, when the irradiation range of the laser light 34 (in particular, the range from the laser light source to the focal point within the substrate 10) overlaps with the modified portion 35 that is to be the through hole 13, due to the change in the refractive index of the modified portion 35, there is a risk of the focal point position of the laser light 34 shifting in the range where the laser light 34 and the modified portion 35 overlap. In order to avoid such overlapping with another modified portion 35 that is previously formed, the laser light 34 may not only be irradiated from the first principal surface 11 side, but also be irradiated from the second principal surface 12 side depending on the location.

Then, the substrate 10 in which the modified portions 35 and 36 have been formed is immersed in an etching solution (chemical solution), and the modified portions 35 and 36 are removed from the substrate 10 by etching (wet etching). As a result, as shown in FIG 14C, the through hole 13 and the fluidic channel 31 are formed at the portions where the modified portions 35 and 36 existed. In the present embodiment, it is possible to use silica glass as the substrate 10, and use a liquid solution including hydrofluoric acid (HF) as the main component as the etching solution. This etching utilizes the fact that the modified portions 35 and 36 are etched extremely quickly compared to the portions of the substrate 10 that have not been modified. As a result, it is possible to form the through hole 13 and the fluidic channel 31 in accordance with the shape of the modified portions 35 and 36.
In the present embodiment, the hole diameter of the micro hole 13 is 50 µm. The hole diameter of the micro hole 13 can be suitably set from around 10 µm to 300 µm in accordance with the use of the through-hole interconnection 16. The hole diameter of the fluidic channel 31 may be comparable to the hole diameter of the micro hole 13, or may be smaller (finer) or larger (fatter). The hole diameter of the fluidic channel 31 is not particularly limited, but for example can be around 10 µm to 500 µm. Also, the hole diameter of the fluidic channel 31 may have a partially fine portion or a partially fat portion.
Note that the etching liquid is not limited to hydrofluoric acid, and it is possible to use a hydrofluoric/nitric acid-based mixed acid in which a suitable amount of nitric acid or the like is added to hydrofluoric acid, or an alkaline aqueous solution such as potassium hydroxide. In addition, it is possible to use another chemical solution in accordance with the material of the substrate 10.
The material of the substrate 10 is not limited to silica glass, and it is possible to use an insulating substrate such as sapphire, or glass containing other components such as an alkali component, and the thickness thereof can be suitably set from 150 µm to 1 mm.

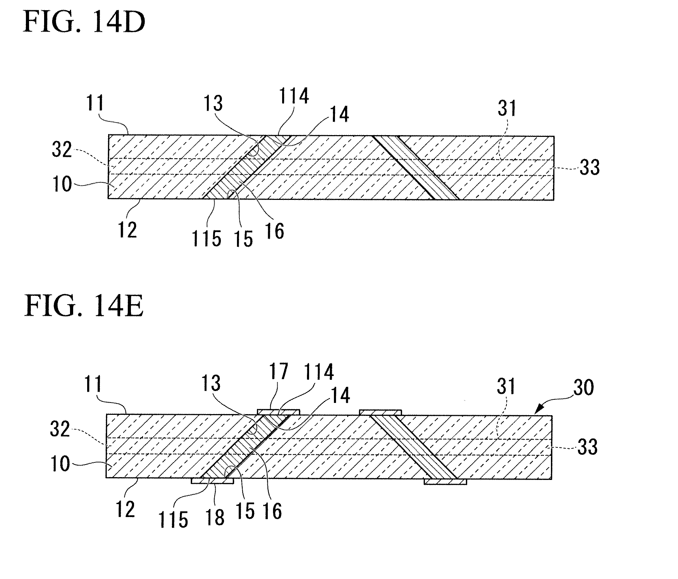

Then, as shown in FIG 14D, the through-hole interconnection 16 is formed by filling the through hole with a conductor or forming a film of a conductor in the through hole 13. For applying the conductor or forming the film of the conductor, it is possible to suitably use a plating method, a sputtering method, a molten metal filling method, chemical vapor deposition, and a supercritical fluid deposition method and the like. At this time, it is preferable to provide a protective layer such as a resist in advance at the position of the entry/exit 32 and 33 of the fluidic channel 31 so that the conductor does not intrude into the fluidic channel 31. As the resist, it is possible to use a resin resist or a thin film made of a non-organic material or the like.

Further, land portions 17 and 18 are formed on the top and bottom of the through-hole interconnection 16 as shown in FIG 14E if necessary. For forming the land portions 17 and 18, it is possible to suitably use a plating method or a sputtering method.

In this manner, if the through hole 13 and the fluidic channel 31 are simultaneously formed, it is possible to simplify the manufacturing steps and lower the cost. Moreover, the positional relation of the through hole 13 and the fluidic channel 31 is easily controlled, it is possible to prevent accidental coupling of the through hole 13 and the fluidic channel 31.
Note that, after forming a plurality of the modified portions 35 and 36, it may not be necessary to form the through holes 13 and the fluidic channels 31 by etching all of the modified portions 35 and 36. For example, by providing a protective layer such as a resist at both ends of some of the modified portions 35 and 36 to protect them from being etched, it is possible to select the modified portions 35 and 36 that are to be subject to etching. Thereby, the through hole 13 and the fluidic channel 31 can be formed only at the necessary positions.
For example, after forming the modified portions 35 in advance so as to correspond to all of the electrodes 3 and 4 of the devices 1 and 2, in the case of there no longer being a need to provide the through-hole interconnection 16 for some of the electrodes 3 and 4 in accordance with the use of the devices 1 and 2, those modified portions 35 corresponding to the portions where through-hole interconnection 16 are not required can be protected so as not to be etched, so that the through holes 13 are not opened. In this way, after uniformly forming the modified portions 35 in the stage of forming the modified portions 35, the positions, where the through-hole interconnection 16 are to be formed, can be selected in the etching stage. Thus, control of the irradiation positions of the laser light for forming the modified portions 35 becomes easy.

Although a method of forming the modified portions 35 and 36 that have a desired shape in the substrate 10 by controlling the focal point position of the laser light from the femtosecond laser in the formation process of the through hole (micro hole) 13 and/or the fluidic channel 31 is described above, the present invention is not limited thereto.
For example, it is possible to collectively form modified portions that have a desired shape in the substrate by arranging a hologram in which a pattern corresponding to the desired shape of the modified portions 35 and 36 is recorded between the femtosecond laser and the substrate, and radiating laser light on the substrate through the hologram. Afterward, it is possible to form the desired through hole (micro hole) and/or fluidic channel by etching those modified portions.

### INDUSTRIAL APPLICABILITY

Using a interposer substrate that has through-hole interconnection that penetrate the substrate, the present invention can be widely used for mounting devices on both sides thereof.

### DESCRIPTION OF REFERENCE NUMERALS

- 1: first device
- 2: second device
- 3, 4: electrode
- 10: substrate
- 11: first principal surface (one principal surface)
- 12: second principal surface (other principal surface)
- 13: through hole (micro hole)
- 14: first opening portion
- 15: second opening portion
- 16: through wire
- 19, 19A, 19B, 19C: through-wiring substrate
- 30, 30A, 30B: through-wiring substrate with flow passage
- 31: flow passage
- 35, 36: modified regions (modified portions)

## Claims

1. A device mounting structure comprising:
a interposer substrate that comprises a substrate and a plurality of through-hole interconnections that are formed within a plurality of through holes that penetrate the substrate from a first principal surface that is one principal surface of the substrate to a second principal surface that is the other principal surface;
a first device that comprises a plurality of electrodes, with the electrodes arranged so as to face the first principal surface; and
a second device that comprises a plurality of electrodes whose arrangement is different from the arrangement of the electrodes of the first device, with the electrodes arranged so as to face the second principal surface, wherein
each through-hole interconnection comprises a first conductive portion that is provided at a position on the first principal surface corresponding to the electrode of the first device, and a second conductive portion that is provided at a position on the second principal surface corresponding to the electrode of the second device,
each electrode of the first device is electrically connected with the first conductive portion, and
each electrode of the second device is electrically connected with the second conductive portion.

2. The device mounting structure according to claim 1, wherein each through-hole interconnection has substantially a linear shape that connects the first conductive portion and the second conductive portion.

3. The device mounting structure according to claim 1 or claim 2, wherein a fluidic channel is provided within the substrate.

4. A device mounting method comprising:
a step of preparing a first device that comprises a plurality of electrodes, and a second device that comprises a plurality of electrodes whose arrangement differs with the arrangement of the electrodes of the first device;
a through hole formation step of forming a plurality of through holes that penetrate a substrate from a first principal surface that is one principal surface of the substrate to a second principal surface that is the other principal surface of the substrate so as to open at positions of the first principal surface corresponding to the electrodes of the first device, and at positions of the second principal surface corresponding to the electrodes of the second device;
a through-hole interconnection formation step, by filling each of the through holes with a conductor or forming a film of the conductor in each of the through holes, forming through-hole interconnection that comprise a first conductive portion exposed at the first principal surface side and a second conductive portion exposed at the second principal surface side; and
a mounting step of arranging the first device so as to face the first principal surface of the substrate and connecting each electrode of the first device to the corresponding first conductive portion, and arranging the second device so as to face the second principal surface of the substrate and connecting each electrode of the second device to the corresponding second conductive portion.

5. The device mounting method according to claim 4, wherein a fluidic channel is formed within the substrate in the through-hole interconnection formation step.

6. The device mounting method according to claim 5, wherein the through hole formation step comprises a step of modifying the regions where the through holes are to be formed and the regions where the fluidic channels are to be formed in the substrate, and a step of removing the modified regions by etching.
